# NEUE EUROPÄISCHE PATENTSCHRIFT

(11) **EP 3 610 050 B2**
(45) Veröffentlichungstag und Bekanntmachung des Hinweises auf die Entscheidung über den Einspruch: **22.01.2025**
(45) Hinweis auf die Patenterteilung: 01.09.2021
(21) Anmeldenummer: 18717332.3
(22) Anmeldetag: 10.04.2018
(51) Int. Cl.: C23C 14/00, C23C 14/06, C23C 14/24, C23C 14/54

(54) **BESCHICHTUNGSVERFAHREN ZUR REAKTIVEN DAMPFPHASENABSCHEIDUNG UNTER VAKUUM AUF EINEM SUBSTRAT**
COATING METHOD FOR REACTIVE VAPOR PHASE DEPOSITION ON A SUBSTRATE UNDER VACUUM
PROCÉDÉS DE REVÊTEMENT PERMETTANT LE DÉPÔT RÉACTIF EN PHASE VAPEUR SOUS VIDE SUR UN SUBSTRAT

(30) Priorität: 11.04.2017 DE 102017003516
(43) Veröffentlichungstag der Anmeldung: 19.02.2020
(73) Patentinhaber: M. Braun Inertgas-Systeme GmbH, 85748 Garching b. München (DE)
(72) Erfinder: DRECHSEL, Jens, 01277 Dresden (DE)
(74) Vertreter: v. Bezold & Partner Patentanwälte - PartG mbB
(86) Internationale Anmeldenummer: PCT/EP2018/059106
(87) Internationale Veröffentlichungsnummer: WO 2018/189147

(56) Entgegenhaltungen:
- WO-A1-2006/111180
- WO-A1-2016/021112
- DE-C1- 4 225 352
- JP-A- 2004 035 325
- JP-A- 2009 149 919
- US-A- 5 091 335
- US-A1- 2012 285 381
- FAEBIAN: "Essential maintenance: MBE bake out", FAEBIAN BATISMAN, 26 November 2012 (2012-11-26), Retrieved from the Internet <URL:https://faebianbastiman.wordpress.com/2012/11/26/mbe-bake-out/> [retrieved on 20220620]
- https://faebianbastiman.wordpress.eom/2012/11/26/mbe-bake-out/Article on the blog pgae Of Mr Fabian Bastiman. published in 2012:
- Doctoral thesis "Molecular Beam Epitaxy Growth Technology and Properties of GaAsBi Alloys" by Ryan B. Lewis, The University of British Columbia. 2014:
- Extract from "Molecular Beam Epitaxy. Fundamentals and Current Status'" by Marian A. Herman and Helmut Sitter, 2013, Springer Science & Business Media;
- Internet page:httpsj//web.archive.org/web/20160330012940/http://www.mbe- komponenten.de/products*iin>ecomponents/ effusion-cells/ome.php,taken from from "archive.org”

## Beschreibung

Die Erfindung betrifft ein Verfahren zur Beschichtung eines Substrats mittels einer Beschichtungsvorrichtung. Anwendungen der Erfindung sind bei der Herstellung von Schichten durch reaktive Dampfphasenabscheidung, insbesondere bei der Herstellung von Perowskit-Schichten (Schichten aus Perowskit-Verbindungen), z. B. für Solarzellen gegeben.

Es sind zahlreiche Perowskit-Verbindungen (oder: Perowskite) bekannt, die eine Klasse von Materialien mit der gleichen Kristallstruktur wie Kalziumtitanat und der allgemeinen chemischen Formel ABX₃ ("A" und "B" sind Kationen von sehr unterschiedlichen Größen und "X" ist ein Anion, das an beide Kationen bindet) darstellen. Basierend auf Materialeigenschaften, wie z. B. Supraleitfähigkeit, Magnetwiderstand, elektrische Eigenschaften und dielektrische Eigenschaften, haben Perowskite eine breite Palette von Anwendungen, insbesondere in der Elektronik und Telekommunikation und in jüngster Zeit besonders in der Dünnschicht-Photovoltaik (PV). Die gängigsten Materialien für hybride organisch-anorganische Perowskit-Solarzellen sind Blei- oder Zinnhalogenid-basierte Materialien. Beispiele sind Methylammonium-Blei-Trihalogenid (CH₃NH₃PbX₃) und Formamidin-Blei-Trihalogenid (H₂NCHNH₂PbX₃), wobei die Halogene (X) I, Br oder Cl sind.

Perowskit-basierte Solarzellen haben hohe Wirkungsgrade, die von 3,8% im Jahr 2009 auf 22,1% im Jahr 2016 gestiegen sind, wobei künftig Wirkungsgrade von 31% erwartet werden. Es besteht daher ein Interesse, Perowskit-basierte Solarzellen massenhaft, kostengünstig und mit reproduzierbar einstellbaren Eigenschaften herzustellen. Ähnlich wie bei organischen Leuchtdioden (OLED) und organischer PV (OPV) kann die Abscheidung eines Perowskit-Dünnfilms durch ein lösungsbasiertes Verfahren (z.B. Bedrucken, Schlitzgießen etc.) oder durch physikalische Dampfphasenabscheidung unter Vakuum realisiert werden.

Die Dampfphasenabscheidung von Perowskit-Schichten, umfassend eine Co-Verdampfung eines organischen Vorläufers (organisches Halogenid, z. B. Methylammoniumjodid) und eines anorganischen Vorläufers (Metallhalogenid, z. B. Blei (II)-iodid), stellt eine Herausforderung an die Prozesskontrolle dar (siehe z. B. WO 2016/021112 A1). Während der anorganische Vorläufer einfach im Hochvakuum verdampft werden kann (ähnlich wie OLED-Materialien oder Metalle), verhält sich der organische Vorläufer typischerweise aufgrund seines niedrigen Molekulargewichts und seiner niedrigen Verdampfungstemperatur "Dampf-Gas-artig": Das Erhitzen einer Verdampferquelle, die mit dem organischen Vorläufer beschickt ist, führt zu einer starken Zunahme des Partialdrucks in der Vakuumkammer einer Beschichtungsvorrichtung und zur unkontrollierten Abscheidung des Materials auf allen Kammeroberflächen. Die Ablagerung und Wiederverdampfung von allen Kammeroberflächen erschwert die Erfassung und Einstellung der tatsächlichen Abscheidungsrate des organischen Vorläufers auf dem Substrat. Die Abscheidungsrate des organischen Vorläufers kann des Weiteren von der Umgebungstemperatur der Beschichtungsvorrichtung und dem Zustand der Vakuumkammer (frisch gereinigt oder bereits verwendet) abhängen. Im Ergebnis der schwierigen Prozesskontrolle zeichnen sich herkömmliche, durch Dampfphasenabscheidung hergestellte Perowskit-Schichten durch eine beschränkte Genauigkeit und Reproduzierbarkeit der Zusammensetzung aus, was sich auf die Funktion und insbesondere den Wirkungsgrad der Solarzellen ungünstig auswirkt.

Ein weiteres Problem der bisher angewendeten Dampfphasenabscheidung ergibt sich daraus, dass die verwendeten anorganischen Vorläufer (Halogenide) als Oxidationsmittel dienen. Durch den hohen Partialdruck bei der Verdampfung werden alle Kammeroberflächen beschichtet und in der Kammer eine korrosive Atmosphäre erzeugt. Alle Materialien der Vakuumkammer müssen so gewählt sein, dass sie mit dieser korrosiven Atmosphäre kompatibel sind. Des Weiteren muss das Pumpensystem der Beschichtungsvorrichtung gegen die korrosive Atmosphäre geschützt werden.

Schließlich haben herkömmliche Beschichtungsvorrichtungen Nachteile in Bezug auf den beschränkten Schutz von Bedienpersonen. Die Vorläufersubstanzen können gefährliche Stoffe enthalten, vor denen Bedienpersonen z. B. bei Wartungsarbeiten geschützt werden müssen.

Die genannten Probleme treten nicht nur bei der Herstellung von Perowskit-Schichten auf, sondern auch bei der reaktiven Dampfphasenabscheidung anderer anorganisch/organischer Mischschichten, bei denen mindestens eine Vorläufersubstanz eine Verdampfungstemperatur nahe, gleich oder sogar unter der Normal-Raumtemperatur hat.

DE 42 25 352 C1 offenbart eine Beschichtungsvorrichtung mit einer Innenkammer. Aus US 2012/285381 A1 ist eine Verdampfungsvorrichtung mit einer Innenkammer bekannt, deren Temperatur auf eine gewünschte Verdampfungstemperatur einer zu verdampfenden Substanz erhöht werden kann. In WO 2006/111180A1 wird eine Beschichtungsvorrichtung beschrieben, bei der ein Verdampfer und ein Abscheidungskörper thermisch entkoppelt sind.

Die Aufgabe der Erfindung ist es, ein verbessertes Verfahren zur Beschichtung eines Substrats mittels reaktiver Dampfphasenabscheidung bereitzustellen, mit dem Nachteile herkömmlicher Techniken vermieden werden. Mit der Erfindung sollen insbesondere die Prozesssteuerung der reaktiven Dampfphasenabscheidung von Substanzen mit niedriger Verdampfungstemperatur verbessert werden, der Schutz der Beschichtungsvorrichtung gegen korrodierende Substanzen verbessert und/oder die Risiken für Bedienpersonen bei der reaktiven Dampfphasenabscheidung verringert werden.

Diese Aufgaben werden durch ein Verfahren mit den Merkmalen des Anspruchs 1 gelöst. Vorteilhafte Ausführungsformen und Anwendungen der Erfindung ergeben sich aus den abhängigen Ansprüchen.

Es wird eine Beschichtungsvorrichtung (keine Ausführungsform der Erfindung) beschrieben, die zur reaktiven Dampfphasenabscheidung unter Vakuum auf einem Substrat konfiguriert ist und eine evakuierbare Vakuumkammer, eine Verdampfereinrichtung, die zur Bereitstellung von Verdampfungsgut, insbesondere umfassend mindestens eine Beschichtungssubstanz oder mindestens zwei Vorläufersubstanzen, in der Dampfphase eingerichtet ist, und eine Substrathalterung zur Aufnahme des Substrates umfasst. Die Verdampfereinrichtung umfasst eine oder mehrere Verdampferquellen. Die reaktive Dampfphasenabscheidung umfasst die Abscheidung mindestens einer Schicht, deren Zusammensetzung durch eine chemische Reaktion des Verdampfungsguts in einem Dampfabschnitt zwischen der Verdampfereinrichtung und der Substrathalterung und/oder auf dem Substrat gebildet wird. Beispielsweise kann die chemische Reaktion der mindestens einen Beschichtungssubstanz auf dem Substrat die Schichtzusammensetzung bilden, oder die mindestens zwei Vorläufersubstanzen können im Dampfabschnitt und/oder auf dem Substrat reagieren. Das Verdampfungsgut kann fest oder flüssig sein.

Gemäß der Erfindung ist in der Vakuumkammer eine temperierbare Innenkammer angeordnet, die den Dampfabschnitt zwischen der Verdampfereinrichtung und der Substrathalterung umgibt. Vorzugsweise ist die Substrathalterung an einer Seite der Innenkammer gegenüber der Verdampfereinrichtung angeordnet. Die Innenkammer ist für eine Einstellung einer Innenkammer-Temperatur, insbesondere der Wände der Innenkammer und in dem von den Wänden begrenzten Dampfabschnitt, gleich oder kleiner 25 °C eingerichtet. Im Dampfabschnitt ist ein Wärmestrahlungsfeld (Temperaturfeld) gebildet, das durch die Temperatur der Innenkammerwände bestimmt wird. Die Form des Wärmestrahlungsfeldes wird ggf. durch die Temperatur der Verdampfereinrichtung und der Substrathalterung beeinflusst.

Gemäß der Erfindung wird die o. g. Aufgabe durch ein Verfahren zur Beschichtung eines Substrats mittels der Beschichtungsvorrichtung gelöst, bei dem Verdampfungsgut mit der Verdampfereinrichtung in die Dampfphase überführt wird, wobei die Verdampfereinrichtung auf eine Verdampfungstemperatur des Verdampfungsguts und die Innenkammer auf eine Innenkammer-Temperatur unterhalb der Verdampfungstemperatur des Verdampfungsguts eingestellt werden, und auf dem Substrat mindestens eine Schicht durch eine reaktive Abscheidung des Verdampfungsguts gebildet wird. Mit dem Begriff "Verdampfungstemperatur" wird die Temperatur bezeichnet, bei der das Verdampfungsgut im Hochvakuum mit einem für die Schichtabscheidung ausreichenden Dampfstrom in die Dampfphase übergeht oder sublimiert wird.

Vorzugsweise ist die Innenkammer-Temperatur niedriger als die Umgebungstemperatur der Beschichtungsvorrichtung. Die Verdampfungstemperatur ist vorzugsweise im Bereich von - 50 °C bis 600 °C gewählt, während die Innenkammer-Temperatur bis in den Bereich von - 40 ° C und - 80 °C oder darunter, z. B. bis -120 °C oder bis zur Temperatur des flüssigen Stickstoffs, -196 °C, abgesenkt sein kann.

Vorteilhafterweise erstreckt sich die Innenkammer von der Verdampfereinrichtung bis zur Substrathalterung, so dass im Dampfabschnitt (Innenraum der Innenkammer) die Innenkammer-Temperatur wirkt. Vorzugsweise ist der Dampfabschnitt allseits von Wänden der Innenkammer umgeben, wobei Öffnungen zur Evakuierung der Innenkammer über die übrige Vakuumkammer vorgesehen sind. Die Temperatur in der Umgebung der Verdampfereinrichtung, insbesondere im Raum über mindestens einer Dampfaustrittsöffnung der Verdampfereinrichtung und beim Transport des Verdampfungsguts zum Substrat ist um ein Temperaturintervall ΔT gegenüber der Umgebungstemperatur der Beschichtungsvorrichtung, z. B. der normalen Raumtemperatur, abgesenkt. Das Temperaturintervall ΔT ist in Abhängigkeit von der Verdampfungstemperatur und optional von der Reaktionstemperatur des Verdampfungsguts wählbar, so dass die Innenkammer-Temperatur geringer als die Verdampfungstemperatur des Verdampfungsguts ist. Wenn eine Dampfphasenreaktion des Verdampfungsguts im Dampfabschnitt vorgesehen ist, ist die Innenkammer-Temperatur vorzugsweise gleich oder oberhalb der Reaktionstemperatur des Verdampfungsguts wählbar.

Durch die Absenkung der Temperatur in der Innenkammer gegenüber der Umgebungstemperatur wird vorteilhafterweise ermöglicht, selbst bei Verdampfungsgut oder dessen Bestandteilen mit einer niedrigen Verdampfungstemperatur, z. B. im Bereich von - 30 °C bis 150 °C, im Dampfabschnitt Hochvakuumbedingungen (Vakuum bevorzugt im Bereich von 10⁻³ mbar bis 10⁻¹⁰ mbar, Hoch- und Ultrahochvakuum) zu schaffen, wobei sich die Moleküle des Verdampfungsguts innerhalb der Verdampfercharakteristik der Verdampfereinrichtung gerichtet und entlang gerader Dampfwege (ballistische Verhalten), insbesondere hin zur Substrathalterung mit dem Substrat bewegen. Moleküle des Verdampfungsguts treffen zwar auch auf die Innenkammer, wo sie jedoch abweichend von herkömmlichen Techniken kondensieren, so dass eine Wiederverdampfung ausgeschlossen bzw. bis auf ein vernachlässigbares Maß reduziert wird. Abschirmelemente, wie z. B. Verdampferblenden zur Strahlformung oder Shutter, und/oder Sensoren, wie z. B. mindestens ein Dickensensor, können in der Innenkammer platziert werden, ohne in ihrer Funktion durch einen ungerichteten Molekültransport beeinträchtigt zu sein. Hierzu kann es von Vorteil sein, dass auch die genannten Elemente aktiv und/oder passiv temperiert sind. Beispielsweise können Abschirmelemente und/oder Sensoren thermisch mit einer Kühl- oder Heizeinrichtung gekoppelt sein. Die Prozesssteuerung, insbesondere basierend auf der Einstellung der Betriebstemperatur der Verdampfereinrichtung und optional weiterer Komponenten der Beschichtungsvorrichtung, wird erheblich vereinfacht.

Neben der Einstellung der Temperatur des Gesamtsystems, in dem der Dampf erzeugt, transportiert und niedergeschlagen wird, wirkt die Innenkammer vorteilhafterweise als Kühlfalle, an der sich ggf. gesundheitsschädliche und/oder korrosive Substanzen niederschlagen. Vorteilhafterweise werden damit die Sicherheit der Bedienpersonen erhöht und andere Teile der Beschichtungsvorrichtung vor Korrosion geschützt.

Die Innenkammer und die Prozesskomponenten, wie Quellen, Abschirmelemente und/oder Sensoren, sind vorzugsweise mit einer korrosionsbeständigen Innenoberfläche hergestellt. Es können korrosionsbeständige Beschichtungen mittels Metallisierung (Vernickeln, Vergolden) und/oder durch Verwendung von Keramiken bzw. keramischen Beschichtungen (Emaille) und/oder von Polymeren (bspw. PTFE) vorgesehen sein.

Gemäß der Erfindung umfasst die Verdampfereinrichtung mindestens eine Wärmetauscher-Verdampferquelle. Die Wärmetauscher-Verdampferquelle ist für eine Einstellung der Betriebstemperatur zur Verdampfung von Verdampfungsgut durch einen Wärmetauscher in Verbindung mit einem Temperierungsmittel-Kreislauf eingerichtet. Die Wärmetauscher-Verdampferquelle umfasst einen Verdampfer mit einem Tiegel zur Aufnahme des Verdampfungsguts und einen Wärmetauscher, der über den Temperierungsmittel-Kreislauf mit einem Temperierungsmittel-Reservoir verbunden ist. Die Wärmetauscher-Verdampferquelle bietet z. B. im Unterschied zu einem herkömmlichen Verdampfer mit Widerstandsheizung den Vorteil einer indirekten Temperierung des Verdampfers. Das Temperierungsmittel, wie z. B. ein Kryoöl, wird mit einer definierten Temperatur bereitgestellt und unerwünschte Temperaturschwankungen können im Temperierungsmittel-Kreislauf vermieden werden, wodurch die Genauigkeit und Reproduzierbarkeit der Steuerung der Verdampferquelle verbessert wird.

Besonders bevorzugt ist die mindestens eine Wärmetauscher-Verdampferquelle durch eine Innenkammer-Wand in die Innenkammer ragend angeordnet. Die Innenkammer-Wand weist für jede Wärmetauscher-Verdampferquelle eine Öffnung auf, durch die die jeweilige Wärmetauscher-Verdampferquelle vorzugsweise mit einem Abstand von der Innenkammer-Wand ragt. Der Abstand von der Innenkammer-Wand bietet Vorteile für die thermische Entkopplung der Wärmetauscher-Verdampferquelle von der Innenkammer-Wand und für die Evakuierung der Innenkammer. Im Übrigen ist die Innenkammer-Wand in der Umgebung der mindestens einen Wärmetauscher-Verdampferquelle vorzugsweise geschlossen. Vorteilhafterweise wird mit dieser Ausführungsform der Erfindung das Strahlungsfeld in der Innenkammer durch die Wärmetauscher-Verdampferquelle minimal beeinflusst, so dass die Prozesssteuerung weiter verbessert wird. Der Verdampfer ist vorzugsweise in eine Wand der Innenkammer, typischerweise deren Bodenwand, eingelassen, so dass die Öffnung des Tiegels zum Dampfabschnitt hin frei liegt. Der Verdampfer kann in der Innenkammer vorstehen oder so angeordnet sein, dass die Öffnung des Tiegels mit der Innenoberfläche der Innenkammer fluchtend ausgerichtet ist.

Die Verdampfereinrichtung kann mehrere Wärmetauscher-Verdampferquellen umfassen, die jeweils über einen zugehörigen Temperierungsmittel-Kreislauf mit dem Temperierungsmittel-Reservoir verbunden sind. Die Wärmetauscher-Verdampferquellen, die jeweils für eine bestimmte Vorläufersubstanz vorgesehen sind, können durch die Einstellung des zugehörigen Temperierungsmittel-Kreislaufs einzeln angesteuert werden. Vorteilhafterweise wird damit die Herstellung von Mehrfach-Schichtstrukturen, insbesondere für p-i-n Solarzellen oder Tandemzellen, vereinfacht. Insbesondere sind jedoch auch Mehrfachbeschichtungen mit mehr als 2 Beschichtungsmaterialien (Ko-Verdampfung) gleichzeitig umsetz- und kontrollierbar.

Vorteilhafterweise wird die Einstellung des Temperierungsmittel-Kreislaufs vereinfacht, wenn dieser ein Heizelement enthält, das stromaufwärts von der jeweiligen Wärmetauscher-Verdampferquelle angeordnet ist. Das Heizelement, umfassend zum Beispiel einen Widerstandsheizer, ist für eine Erwärmung des Temperierungsmittels von der Temperatur im Temperierungsmittel-Reservoir auf die gewünschte Betriebstemperatur des angeschlossenen Verdampfers ausgelegt. Entsprechend ist das Temperierungsmittel-Reservoir vorzugsweise zur Rück-Kühlung des Temperierungsmittels auf eine Temperatur unterhalb von 80 °C, insbesondere unterhalb von 10 °C oder unterhalb von - 10 °C eingerichtet. Mit dem Heizelement ist eine Temperatur des Temperierungsmittels z. B. im Bereich von -10 °C bis 200 °C einstellbar.

Die mindestens eine Wärmetauscher-Verdampferquelle kann einen Temperierungsblock umfassen, z. B. aus Kupfer, der thermisch mit dem Temperierungsmittel-Kreislauf gekoppelt ist und in den der Tiegel zur Aufnahme des Verdampfungsguts eingelassen ist. Die Bereitstellung des Temperierungsblocks bietet Vorteile für eine gleichmäßige Erwärmung des Tiegels und die Vermeidung unerwünschter Temperaturschwankungen.

Weitere Vorteile für die Prozesssteuerung, insbesondere die Einstellung der Temperatur im Tiegel der Verdampferquelle, ergeben sich aus den folgenden Merkmalen, die einzeln oder in Kombination vorgesehen sein können. Der Temperierungsblock kann mindestens eine Wärmetauscher-Leitung enthalten, die mit dem Temperierungsmittel-Kreislauf verbunden ist. In diesem Fall wird der Temperierungsblock vorteilhafterweise direkt durch das Temperierungsmittel temperiert. Der Tiegel der Verdampferquelle und der Temperierungsblock sind über ein Gewinde gekoppelt. Ein Außengewinde des Tiegels sitzt in einem Innengewindes des Temperierungsblocks. Die Gewindeverbindung bietet mehrere Vorteile, insbesondere hinsichtlich der Austauschbarkeit des Tiegels und der im Vergleich zu einem flächigen Steckkontakt vergrößerten Kontaktfläche zwischen dem Tiegel und dem Thermoblock, so dass der Wärmefluss zum Tiegel optimiert wird. Des Weiteren kann der Temperierungsblock über Steckverbinder mit dem Temperierungsmittel-Kreislauf verbunden sein. Steckverbinder weisen Kontaktflächen auf, welche vorteilhafterweise den Wärmefluss zum Thermoblock optimieren. Vorzugsweise weisen die Steckverbinder Kontaktlamellen zur großflächigen thermischen Anbindung auf. Alternativ sind andere Verbindungstypen, wie z. B. Löten, möglich. Des Weiteren kann der Temperierungsblock mit einem Temperatursensor ausgestattet sein, so dass sich Vorteile für eine Überwachung der aktuellen Betriebstemperatur der Verdampferquelle die im Tiegel und/oder am Tiegel ergeben.

Die Verdampferquelle ist besonders als Abscheidungsquelle für die organische Halogenidabscheidung geeignet. Sie bietet Vorteile für die Verbesserung der Prozesskontrolle, was zu einer höheren Wiederholbarkeit der nachfolgenden Schichtdepositionen führt. Darüber hinaus werden zusätzliche Freiheitsgrade zur Feinabstimmung insbesondere der Perowskitablagerung geschaffen. Die Beschichtungsvorrichtung ist daher nicht nur für die Schichtproduktion, sondern auch als Werkzeug für die Grundlagenforschung geeignet.

Die Erfindung ist nicht auf die Verwendung der Wärmetauscher-Verdampferquelle mit dem einen Tiegel beschränkt. Alternativ sind andere Quellen, die vorzugsweise auf der beschriebenen Wärmetauscher-Temperierung basieren, jedoch andere Größen und/oder Formen aufweisen, verwendbar. Hierzu zählen z. B. Flächenquellen, Linearverdampfer oder Verdampfer mit mehreren Tiegeln. Diese haben besondere Vorteile für die Anwendung der Erfindung in der industriellen Schichtproduktion.

Gemäß der Erfindung ist die Innenkammer mit einer Kühleinrichtung gekoppelt, mit der die Innenkammer-Temperatur, vorzugsweise unterhalb einer Umgebungstemperatur der Beschichtungsvorrichtung, einstellbar ist. Die Kühleinrichtung umfasst z. B. einen Kühlmittel-Kammerkreislauf, einen Hydroform-Wärmetauscher und/oder eine Passiv-Kühlung mit mindestens einem Kühlstempel. Vorzugsweise enthält der Kühlmittel-Kammerkreislauf als Temperierungsmittelquelle das Temperierungsmittel-Reservoir zur Temperierung der Verdampfereinrichtung, wodurch vorteilhafterweise der Aufbau der Beschichtungsvorrichtung vereinfacht wird. Besonders bevorzugt ist die Kühleinrichtung für eine Einstellung der Temperatur der Innenkammer unterhalb von - 20°C, besonders bevorzugt - 40 °C, z. B. im Bereich von - 40°C bis - 80 °C, oder sogar bis - 196 °C, vorgesehen.

Wenn die Substrathalterung unabhängig von der Innenkammer temperierbar, insbesondere heizbar ist und vorzugsweise von der Innenkammer thermisch entkoppelt ist, ergeben sich weitere Vorteile für die Prozesssteuerung, insbesondere die Einstellung einer optimalen Reaktionstemperatur am Substrat. Für die Herstellung von hybriden organisch/anorganischen Mischschicht oder Perowskit-Schichten ist vorzugsweise eine Einstellung der Substrathalterung auf eine Temperatur im Bereich gleich oder oberhalb 25 °C, z. B. im Bereich von 25°C bis 150 °C, insbesondere 80°C bis 100 °C, vorgesehen. Eine Kühlung unterhalb der Umgebungstemperatur (Raumtemperatur) kann auch vorteilhaft sein, z. B. wenn die Reaktionsenergie bereits ausreicht und die Morphologie der Schicht modifiziert werden soll.

Vorzugsweise wird die Substrathalterung an der äußeren Vakuumkammer befestigt. Die Substrathalterung kann z. B. für eine Rotation des Substrats und/oder eine Medienzuführung zum Substrat ausgelegt sein. Die Substrathalterung ist in einer Öffnung in einer Innenkammer-Wand der Innenkammer frei liegend angeordnet.

Gemäß der Erfindung ist die Beschichtungsvorrichtung mit einer Heizeinrichtung ausgestattet, mit der die Vakuumkammer außerhalb der Innenkammer einstellbar ist. Die Vakuumkammer ist unabhängig von der Temperatur der Innenkammer temperierbar, insbesondere heizbar. Vorteilhafterweise kann die Vakuumkammer außerhalb der Innenkammer geheizt werden, ohne dass das Strahlungsfeld in der Innenkammer beeinflusst wird. Falls Substanzen aus der Innenkammer insbesondere über die Öffnungen zur Evakuierung der Innenkammer, wie z. B. Spalte zwischen oder Löcher in den Innenkammerwänden, in die äußere Vakuumkammer austreten, wird mit der Heizeinrichtung der Vakuumkammer ein Niederschlag verhindert. Dämpfe werden zu einer Pumpeinrichtung weiter transportiert, wo sie mit einer Kühlfalle aufgefangen werden. Besonders bevorzugt wird die Vakuumkammer außerhalb der Innenkammer auf eine Außenkammer-Temperatur oberhalb der Umgebungstemperatur der Beschichtungsvorrichtung erwärmt.

Des Weiteren ist die Beschichtungsvorrichtung erfindungsgemäß mit mindestens einem Dickenmessgerät, wie z. B. einem Schwingquarz-Dickensensor, ausgestattet, das in der Innenkammer angeordnet und mit einer Temperierungseinrichtung gekoppelt ist. Die Temperierungseinrichtung ist zur Kühlung des Dickenmessgeräts, während des Betriebs der Beschichtungsvorrichtung, und/oder zur Erwärmung des Dickenmessgeräts, insbesondere während eines Ausheizvorgangs für Reinigungszwecke, konfiguriert. Die Kühlung des Dickenmessgeräts ist vorzugsweise so vorgesehen, dass das Verdampfungsgut, in dessen Dampfweg sich das Dickenmessgerät befindet, zu 100 % anhaftet. Die Temperierung des Dickenmessgeräts erfolgt unabhängig von der Einstellung der Innenkammer-Temperatur und der Verdampferquelle.

Vorteilhafterweise kann die temperierbare Innenkammer von der äußeren Vakuumkammer trennbar angeordnet sein. Die Innenkammer kann aus der Vakuumkammer z. B. für Reinigungszwecke oder für eine Anpassung der Beschichtungsvorrichtung für eine andere Beschichtungsaufgabe, entnommen werden. Die Entnahme kann z. B. unter Verwendung einer Glovebox-Vorrichtung erfolgen.

Die Anwendungen der Beschichtungsvorrichtung werden erweitert, weil die Verdampfereinrichtung gemäß der Erfindung zusätzlich mindestens eine Aktivheizungs-Verdampferquelle, insbesondere mindestens eine Widerstandheizungs-Verdampferquelle, Effusionszelle und/oder mindestens eine Elektronenstrahl-Verdampferquelle umfasst. Die Aktivheizungs-Verdampferquelle ist zur Verdampfung von Verdampfungsgut eingerichtet, dessen Verdampfungstemperatur höher als die Verdampfungstemperatur der mit der Wärmetauscher-Verdampferquelle verdampften Substanz ist.

Vorzugsweise ist die mindestens eine Aktivheizungs-Verdampferquelle thermisch von der Innenkammer entkoppelt, während eine Dampfaustrittsöffnung der Aktivheizungs-Verdampferquelle in die Innenkammer mündet. Vorteilhafterweise ist dadurch eine thermische Wechselwirkung mit dem Strahlungsfeld in der Innenkammer nur über die Dampfaustrittsöffnung gegeben. Das Strahlungsfeld in der Innenkammer wird durch die mindestens eine Aktivheizungs-Verdampferquelle nicht oder nur gering beeinflusst.

Die Beschichtungsvorrichtung kann mit mindestens einer Energiezufuhreinrichtung ausgestattet sein, die zur Förderung und/oder Initiierung einer Reaktion von Verdampfungsgut konfiguriert ist, auf der die reaktive Dampfphasenabscheidung basiert. Die Energiezufuhreinrichtung kann auf das Verdampfungsgut im Dampfabschnitt und/oder auf dem Substrat wirken. Die Reaktion kann z. B. durch Ionen-, Wärme-, Licht-, und/oder Mikrowellenzufuhr aktiviert werden. Entsprechend umfasst die Energiezufuhreinrichtung beispielsweise eine Ionenquelle zum Eintrag von energetisch moderierten Partikeln, welche primär am Ort des Substrates die Reaktion modulieren können, eine Plasmaquelle am Ort des Substrates oder Remote-Plasma zur Aktivierung von einem oder mehreren Reaktionspartnern, eine Mikrowellenquelle, und/oder eine Lichtquelle mit einer Emission im Wellenlängenbereich IR bis UV.

Vorteilhafterweise kann die Beschichtungsvorrichtung mit mindestens einer Abschirmeinrichtung ausgestattet sein, die zwischen der Verdampfereinrichtung und der Substrathalterung mit einem Abstand von der Substrathalterung angeordnet und zur Abschirmung und/oder Strahlformung eines Verdampfungsgut-Stroms in der Dampfphase eingerichtet ist und z. B. mindestens eine Maskeneinrichtung und/oder mindestens einen Wedge-Shutter umfasst. Die Beschichtungsvorrichtung erlaubt insbesondere den Einsatz von strukturierenden Elementen (u. a. Schattenmasken) mit ausreichender Abbildungswirkung (basierend auf der Molekularströmung). Herkömmliche CVD-Schichtbildung erlaubt nur die Verwendung von Kontaktmasken, welche das Substrat berühren, da andernfalls die Maske hinterdampft werden würde. Dazu im Unterschied werden erfindungsgemäß ein ballistischer Dampftransport und eine Dampfabscheidung unter Hoch- oder Ultrahochvakuumbedingung ermöglicht, so dass die Abschirmeinrichtung mit Abstand vom Substrat angeordnet sein kann. Des Weiteren wird die Beschichtungsvorrichtung vorzugsweise frei von Trägergas betrieben.

Gemäß dem erfindungsgemäßen Verfahrens, bei der die Beschichtungsvorrichtung die mindestens eine Wärmetauscher-Verdampferquelle und mindestens eine Aktivheizungs-Verdampferquelle enthält, werden mit der mindestens einen Wärmetauscher-Verdampferquelle jeweils eine organische Vorläufersubstanz verdampft und mit der mindestens einen Aktivheizungs-Verdampferquelle jeweils eine anorganische Vorläufersubstanz verdampft, wobei auf dem Substrat reaktiv aus der mindestens einen organische Vorläufersubstanz und der mindestens einen anorganische Vorläufersubstanz mindestens eine hybride organisch/anorganische Mischschicht oder eine Perowskit-Schicht abgeschieden wird.

Besonders bevorzugt wird ein Stapel aus Schichten verschiedener Zusammensetzungen und/oder Dicken abgeschieden. Insbesondere ermöglicht die Beschichtungsvorrichtung eine kontrollierte Schichtabscheidung bei gleichzeitigem Betrieb von mindestens einer Aktivheizungs-Verdampferquelle und/oder mindestens einer Wärmetauscher-Verdampferquelle (Ko-Verdampfung) beispielsweise um für photoaktive Schichten in einer Solarzelle mit Bandlücken-Tuning zu ermöglichen.

Zusammengefasst bietet die Erfindung die folgenden Vorteile, insbesondere für die Herstellung von Perowskit-Schichten. Die Prozesssteuerung wird verbessert, indem die Innenkammer ein Temperaturfeld zwischen der mindestens einen Verdampferquelle und dem Substrat unabhängig von der Umgebungstemperatur der Beschichtungsvorrichtung und der Temperatur der äußeren Vakuumkammer so einstellt, dass eine geradlinige Molekularströmung des Verdampfungsguts mit der niedrigsten Verdampfungstemperatur wie unter Hochvakuum- oder Ultrahochvakuumbedingungen geschaffen wird. Dies liefert ein echtes Abbildungsverhalten der Dampfwege, das insbesondere eine Maskierung und die Verwendung von Shuttern und voneinander unabhängig arbeitenden Dickenmessgeräten ermöglicht. Mit der Kühlung der Innenkammer wird die in den Dampfabschnitt eingebrachte Wärme aus allen beteiligten Verdampferquellen kompensiert. Vorteilhafterweise wird eine Erwärmung der Beschichtungsvorrichtung selbst bei längerer Betriebszeit vermieden.

Zusätzlich wird eine Re-Verdampfung von inneren Komponenten der Beschichtungsvorrichtung vermieden. Das verdampfte Material haftet dort an, wo es auf eine feste Oberfläche trifft. Lediglich vom Substrat kann es unter bestimmten Bedingungen zu einer Re-verdampfung kommen (z.B. wenn das Substrat eine höhere Temperatur benötigt, um die Reaktion schnell erfolgen zu lassen oder um gezielt Kristallitwachstum zu forcieren). Die Kondensation an den festen Oberflächen bietet zugleich Vorteile für die spätere Wartung der Anlage (Austausch definierter Schirmungen) als auch auf für das Steuern und Messen der jeweiligen Verdampferquellen (Sensoren usw.).

Die Beschichtungsvorrichtung erlaubt es, mehrere Verdampferquellen gleichzeitig und unabhängig zu betreiben werden. Die Verdampferquellen sind auch durch die Kühlung mit der Innenkammer thermisch voneinander entkoppelt, so dass bei reaktiver Abscheidung auf dem Substrat keine substanzielle Wechselwirkung der jeweiligen Dampfströme untereinander auf dem Weg zum Substrat und bei den Schichtdickensensoren auftritt.

Weitere Einzelheiten der Erfindung werden im Folgenden unter Bezug auf die beigefügten Zeichnungen beschrieben. Es zeigen:
- Figur 1:: eine schematische Illustration einer Beschichtungsvorrichtung zur Anwendung des erfindungsgemäßen Verfahrens;
- Figur 2:: weitere Einzelheiten einer Vakuumkammer einer abgewandelten Beschichtungsvorrichtung; und
- Figur 3:: Illustrationen einer bevorzugt verwendeten Verdampferquelle.

Ausführungsformen der Erfindung werden im Folgenden unter beispielhaftem Bezug auf Beschichtungsvorrichtungen beschrieben, die mit zwei Verdampferquellen oder einer einzigen Verdampferquelle (keine Ausführungsform der Erfindung) ausgestattet sind. Die Erfindung ist nicht auf diese Varianten beschränkt, sondern entsprechend mit mehr Verdampferquellen ausführbar. Des Weiteren wird beispielhaft auf die Abscheidung von Perowskit-Schichten zur Herstellung von Solarzellen Bezug genommen. Die Erfindung ist entsprechend mit anderen Materialsystemen anwendbar, wie z. B. bei der Abscheidung von metall-organischen Verbindungen. Einzelheiten der Beschichtungsvorrichtung werden nicht beschrieben, die an sich von herkömmlichen Techniken bekannt sind, wie z. B. Einzelheiten der Pumpeinrichtung, der Überwachung der Vakuumbedingungen, der Schichtdickenmessung, der Stromversorgung, der Steuerung und dgl.. Die Dimensionen der Beschichtungsvorrichtung können in Abhängigkeit von der konkreten Anwendung der Erfindung gewählt werden. Es kann z. B. eine SPS -Steuerung mit Touch-panel und Visualisierung und/oder eine manuelle oder automatische Steuerung der einzelnen Prozesse nach Prozessparametrierung vorgesehen sein.

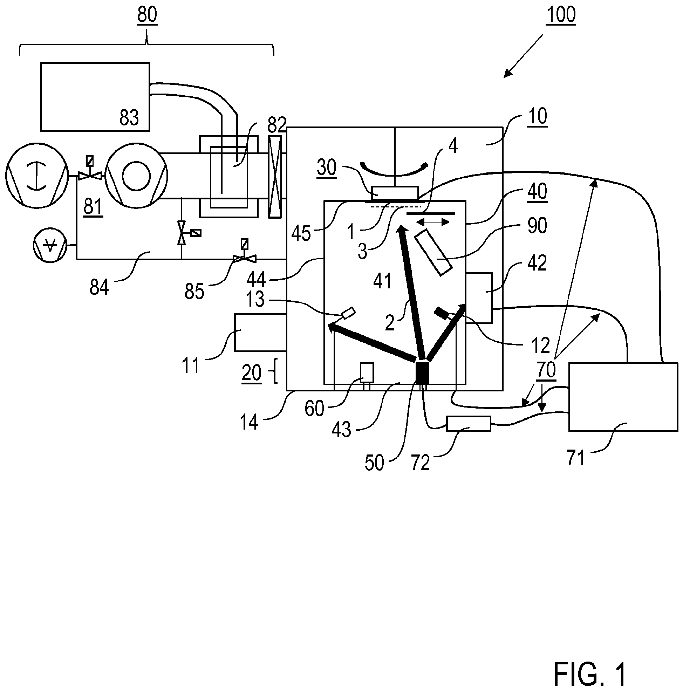

Figur 1 zeigt schematisch eine Beschichtungsvorrichtung 100 mit einer Vakuumkammer 10, einer Verdampfereinrichtung 20, einer Substrathalterung 30, einer Innenkammer 40, einer Wärmetauscher-Verdampferquelle 50, einer Aktivheizungs-Verdampferquelle 60, drei Temperierungsmittel-Kreisläufe 70 und eine Pumpeinrichtung 80.

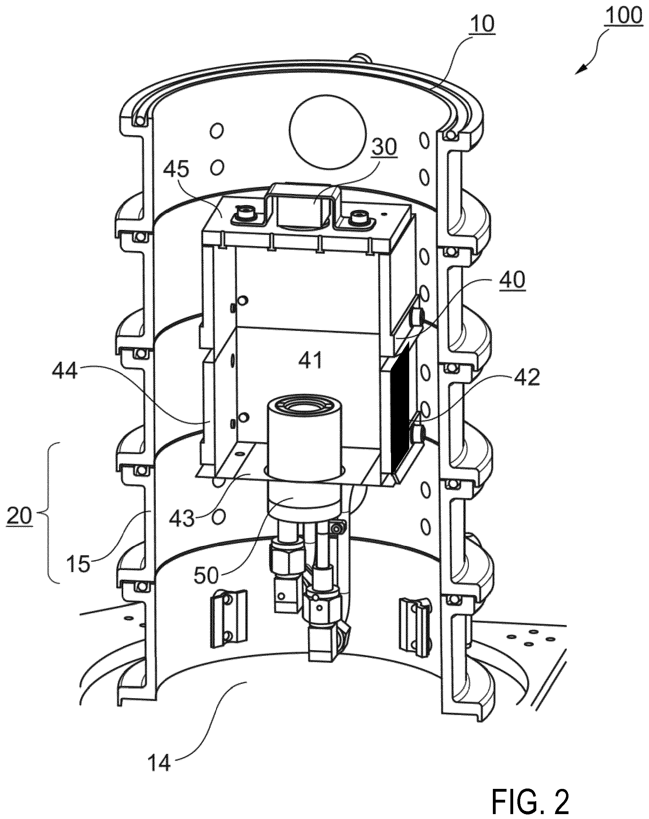

Die Vakuumkammer 10 ist ein Vakuumrezipient, der mit der Pumpeinrichtung 80 evakuierbar und z. B. aus Edelstahl hergestellt ist. Die Innenoberfläche der Vakuumkammer 10 kann elektropoliert oder passiviert sein. Zur Erwärmung der Vakuumkammer 10 über die Temperatur der Innenkammer 40 und über die Umgebungstemperatur ist eine Heizeinrichtung 11, wie z. B. eine Widerstandsheizung oder eine Wärmequelle auf Basis eines flüssigen Mediums, wie z. B. Wasser, vorgesehen. In der Vakuumkammer 10 sind ein Dickenmessgerät 12 zur Erfassung des Dampfstroms von der Wärmetauscher-Verdampferquelle 50 und ein Dickenmessgerät 13 zur Erfassung des Dampfstroms von der Aktivheizungs-Verdampferquelle 60 angeordnet. Die schematisch gezeigte Wand der Vakuumkammer 10 kann einen Boden 14 und eine auf dem Boden 14 aufsetzbare Glocke, eine andere übliche Vakuumkammerform oder mehrere auf dem Boden als Stapel angeordnete Segmente 15 (siehe Figur 2) umfassen. Die Pumpeinrichtung 80 ist über den Boden oder eines der Segmente mit der Vakuumkammer 10 verbunden. Die Vakuumkammer 10 kann mit einer Schiebetür und/oder einer Klapptür, insbesondere für Wartungszwecke (z. B. Befüllung der Verdampferquellen 50, 60 und Tausch von Shutter-Blenden bzw. Bedampfungsschirme) und/oder die Entnahme bzw. den Einbau der Innenkammer 40, einer Kammerbeleuchtung und/oder einem Sichtfenster mit Beschichtungsblende ausgestattet sein.

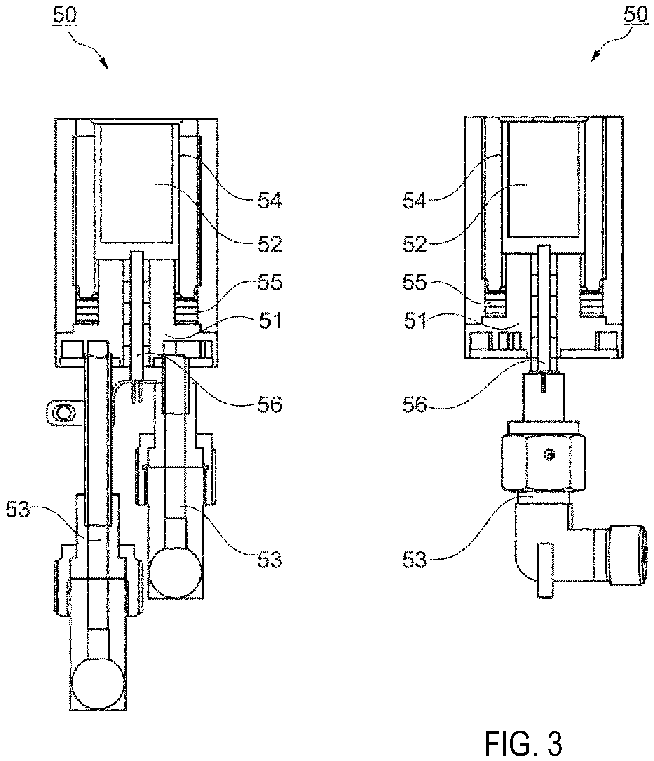

Die Verdampfereinrichtung 20, die zur Bereitstellung von Verdampfungsgut in der Dampfphase eingerichtet ist, umfasst die Wärmetauscher-Verdampferquelle 50 und die Aktivheizungs-Verdampferquelle 60. Die Wärmetauscher-Verdampferquelle 50 ist aufgebaut, wie unten unter Bezug auf Figur 3 beschrieben ist. Die Aktivheizungs-Verdampferquelle 60 ist z. B. eine Verdampferquelle mit einer Widerstandsheizung. Zusätzlich ist die Die Verdampfereinrichtung 20 in an sich bekannter Weise mit Shuttern zur Blockierung oder Freigabe der Verdampferquellen 50, 60 ausgestattet.

Die Substrathalterung 30 ist zur Aufnahme eines Substrates 1 eingerichtet. In der oberen Wand der Innenkammer 40 ist beispielsweise eine Öffnung vorgesehen, in der das Substrat um eine Achse senkrecht zur Substratebene drehbar gehaltert wird. Die Substrathalterung 30 ist mit einem Temperierungsmittel-Kreislauf 70 gekoppelt, der bei der in Figur 1 gezeigten Variante der Erfindung zur Kühlung des Substrats 1 ausgelegt ist. Alternativ oder zusätzlich kann eine Erwärmung des Substrats 1 vorgesehen sein. Zur lateralen Strukturierung der herzustellenden Schichten kann die Substrathalterung mit einer Abschirmeinrichtung, z. B. umfassend ein Maskensystem 3 (Schattenmaske, Kontakt- oder Nicht-Kontaktmaske) ausgestattet sein. Das Substrat 1 kann des Weiteren mit einem Wedge-Shutter 4 (z.B. 1D Doppel-Wedge mit unabhängiger Einstellung der Spaltbreite und Position) mit kontinuierlicher Steuerung während des Beschichtungsprozesses zur unabhängigen Einstellung der Schlitzbreite und Position ausgestattet sein.

Das Substrat 1 hat z. B. eine Substratgröße von bis zu 100 mm x 100 mm oder 150 mm Durchmesser und eine Substratdicke von 0,5 mm bis 3 mm. Das Substratmaterial umfasst z. B. Glas oder Si-Wafer. Die Substrat-Rotation ist z. B. im Bereich von 0 bis 30 U/min gewählt. Das Substrat 1 ist z. B. im Bereich von -10 °C bis 100 °C temperierbar. Diese Beispiele können in Abhängigkeit von der konkreten Anwendung der Erfindung modifiziert werden.

Die Innenkammer 40 ist eine quaderförmige oder zylinderförmige Box, die im Inneren der Vakuumkammer 10 mit Trägerelementen (nicht dargestellt) auf dem Boden 15 oder einer lateralen Wand, z. B. einem der Segmente 15 (siehe Figur 2) lösbar befestigt ist. Die Innenkammer 40 ist segmentiert mit einem Bodensegment 43, Seitensegmenten 44 und einem Deckelsegment 45 aufgebaut (siehe Figur 2). Die Innenkammer 40, insbesondere deren Segmente, ist aus einem korrosionsbeständigen Material, wie z. B. Edelstahl hergestellt. Der Innenraum der Innenkammer 40 bildet einen Dampfabschnitt 41 durch den Dampfwege 2 von den Verdampferquellen 50, 60 zum Substrat 1 verlaufen. Die Innenkammer 40 ist mit einer Kühleinrichtung 42 ausgestattet, die bei der in Figur 1 gezeigten Variante der Erfindung mit einem Temperierungsmittel-Kreislauf 70 gekoppelt ist. Alternativ kann eine gesonderte aktive Kühlung vorgesehen sein. Die Kühleinrichtung 42 umfasst z. B. Kühlleitungen auf der äußeren Oberfläche der Innenkammer 40, insbesondere Kühlschlangen aus Edelstahlblech, mit einem durchfließenden Kühlmittel, Kühlbleche mit einer Mäanderform (Kühlung mit dem Hydroform-Verfahren), eine massive Einhausung mit einer Kühlmittel-basierten oder elektrischen Kühleinrichtung, oder mindestens eine Wärmeleitungsbrücke (Kühlstempel) zur Verbindung der Innenkammer 40 mit einer externen, Kühlmittel-basierten oder elektrischen Kühleinrichtung.

Die Wärmetauscher-Verdampferquelle 50, z. B. mit einem Tiegelvolumen von mindestens 2 cm³, ist über einen Temperierungsmittel-Kreislauf 70 mit einem Temperierungsmittel-Reservoir 71 gekoppelt. Der Temperierungsmittel-Kreislauf 70 umfasst einen Zulauf und einen Rücklauf sowie eine Umlaufpumpe (im Einzelnen nicht dargestellt). Im Zulauf ist ein Heizelement 72 angeordnet, mit dem die Temperatur des Temperierungsmittels einstellbar ist, das der Wärmetauscher-Verdampferquelle 50 zugeführt wird. Die Aktivheizungs-Verdampferquelle 60, z. B. mit einem Tiegelvolumen von mindestens 8 cm³, ist mit einer Stromversorgungseinrichtung (nicht dargestellt) verbunden. Die Temperatur des Temperierungsmittel-Reservoirs 71 wird vorzugsweise so eingestellt, dass der dynamische Regelbereich für die Verdampferquelle durch das Heizelement 72 abgedeckt werden kann.

Die Pumpeinrichtung 80 umfasst Vakuumpumpen 81, die über eine Kühlfalle 82 mit der Vakuumkammer 10 verbunden sind. Die Vakuumpumpen 81 umfassen eine Turbopumpe mit trockener Vorpumpe. Die Kühlfalle 82 wird mit einem Umlaufkühler bzw. einem Flüssigstickstofftank 83 gekühlt, z. B. auf eine Temperatur im Bereich von -196 °C bis -40 °C. Die Kühlfalle 82 ist aus einem korrosionsbeständigen Material, wie z. B. Edelstahl oder Glas hergestellt. Des Weiteren umfasst die Pumpeinrichtung 80 ein automatisiertes Bypass-System 84 mit Torventil 85.

Figur 1 zeigt schematisch auch eine Energiezufuhreinrichtung 90 in Gestalt einer Ionenquelle, die auf das Substrat 1 gerichtet ist. Mit der Ionenquelle wird z. B. ein Fluss von Ar-Ionen erzeugt, mit dem Aktivierungsenergie für die reaktive Dampfphasenabscheidung auf das Substrat 1 zugeführt wird.

Die Beschichtungsvorrichtung 100 gemäß Figur 1 wird betrieben, indem im evakuierten Zustand der Vakuumkammer 10 und der Innenkammer 40 die Wärmetauscher-Verdampferquelle 50 mit einer ersten Vorläufersubstanz, z. B. Methylammonium-Iodid mit einer Verdampfungstemperatur von 50 °C bis 140 °C und die Aktivheizungs-Verdampferquelle 60 mit einer zweiten Vorläufersubstanz, z. B. Pbl mit einer Verdampfungstemperatur von 250 °C beschickt werden, die Innenkammer-Temperatur auf -10°C eingestellt und die Verdampferquellen 50, 60 betätigt werden. Dampfströme 2 bewegen sich zum Substrat 1, dessen Temperatur auf 15 °C eingestellt ist. Flussraten der Dampfströme 2 werden mit den Dickenmessgeräten 12, 13 überwacht. Auf dem Substrat 1 wird die Perowskit-Schicht durch Reaktion der Vorläufersubstanzen gebildet.

Die Beschichtungsvorrichtung 100 gemäß Figur 1 kann in einer Inertgasbox oder Isolatorbox angeordnet sein, z. B. um Luft- oder insbesondere Sauerstoff-empfindliche Materialien zuzuführen und/oder die Innenkammer unter inerten Bedingungen auszuführen. Des Weiteren kann die Pumpeinrichtung 80 der Beschichtungsvorrichtung 100 mit einem Abgasbehandlungssystem ausgestattet sein, um insbesondere toxische und/oder gesundheitsgefährdende Substanzen abzuscheiden.

Figur 2 zeigt eine abgewandelte Variante der Beschichtungsvorrichtung 100 (ohne die Pumpeinrichtung 80), die mit einer einzigen Verdampferquelle 50 ausgestattet ist (keine Ausführungsform der Erfindung). Die Beschichtungsvorrichtung 100 ist mit der Vakuumkammer 10, der Verdampfereinrichtung 20 (Wärmetauscher-Verdampferquelle 50), der Substrathalterung 30, und der Innenkammer 40 dargestellt. Der Temperierungsmittel-Kreislauf zum Betrieb der Wärmetauscher-Verdampferquelle 50 ist nicht gezeigt. Diese Variante kann z. B. zur Schichtabscheidung durch eine Reaktion einer einzigen Vorläufersubstanz und/oder zur Untersuchung des Verdampfungsverhaltens von Vorläufersubstanzen vorgesehen sein.

In einer weiteren Beschichtungsvorrichtung (nicht dargestellt) sind z. B. mindestens sechs unabhängige Verdampferquellen vorgesehen, umfassend zwei Wärmetauscher-Verdampferquellen im niedrigen Temperaturbereich von mindestens -10 °C bis 160 °C und vier Aktivheizungs-Verdampferquelle 60 mit einem erweitertem Temperaturbereich (mindestens 50 °C bis 800 °C).

Figur 3 zeigt Schnittansichten der Wärmetauscher-Verdampferquelle 50 mit einem Thermoblock 51, einem Tiegel 52 und Wärmetauscher-Leitungen 53. Der Tiegel 52 ist über ein Außengewinde 54 und Steckverbinder 55 mit dem Thermoblock 51 gekoppelt. Ein Temperatursensor 56, z. B. ein Thermoelement, ist zur Überwachung der Temperatur der Wärmetauscher-Verdampferquelle 50 vorgesehen.

Die in der vorstehenden Beschreibung, den Zeichnungen und den Ansprüchen offenbarten Merkmale der Erfindung können sowohl einzeln als auch in Kombination oder Unterkombination für die Verwirklichung der Erfindung in ihren verschiedenen Ausgestaltungen von Bedeutung sein.

## Patentansprüche

1. Verfahren zur Beschichtung eines Substrats (1) durch reaktive Dampfphasenabscheidung unter Vakuum mittels einer Beschichtungsvorrichtung (100), die umfasst:
- eine evakuierbare Vakuumkammer (10),
- eine Verdampfereinrichtung (20), die zur Bereitstellung von Verdampfungsgut in der Dampfphase eingerichtet ist und mindestens eine Wärmetauscher-Verdampferquelle (50), die jeweils eine organische Vorläufersubstanz enthält, und mindestens eine Aktivheizungs-Verdampferquelle (60) umfasst, die jeweils eine anorganische Vorläufersubstanz enthält, und
- eine Substrathalterung (30), die zur Aufnahme des Substrates eingerichtet ist, wobei
- in der Vakuumkammer (10) eine temperierbare Innenkammer (40) angeordnet ist, die einen Dampfabschnitt (41) zwischen der Verdampfereinrichtung (20) und der Substrathalterung (30) umgibt und für eine Einstellung einer Innenkammer-Temperatur gleich oder kleiner 25 °C eingerichtet ist, und
- die Innenkammer (40) mit einer Kühleinrichtung (42) gekoppelt ist, mit der die Innenkammer-Temperatur einstellbar ist, mit den Schritten
- Überführung des Verdampfungsguts mit der Verdampfereinrichtung (20) in die Dampfphase, wobei die Verdampfereinrichtung (20) auf eine Verdampfungstemperatur des Verdampfungsguts und die Innenkammer (40) auf die Innenkammer-Temperatur unterhalb der Verdampfungstemperatur des Verdampfungsguts eingestellt werden, und
- Bildung von mindestens einer Schicht auf dem Substrat (1) durch eine reaktive Abscheidung des Verdampfungsguts, wobei aus der mindestens einen organischen Vorläufersubstanz und der mindestens einen anorganischen Vorläufersubstanz mindestens eine hybride organisch/anorganische Mischschicht oder eine Perowskit-Schicht abgeschieden wird, wobei
- die Beschichtungsvorrichtung (100) eine Heizeinrichtung (11) umfasst, mit der die Vakuumkammer (10) außerhalb der Innenkammer (40) unabhängig von der Temperatur der Innenkammer (40) auf eine Außenkammer-Temperatur oberhalb der Umgebungstemperatur der Beschichtungsvorrichtung (100) erwärmt wird, und
- die Beschichtungsvorrichtung (100) mindestens ein Dickenmessgerät (12) umfasst, das mit einer Temperierungseinrichtung gekoppelt ist und unabhängig von der Einstellung der Innenkammer-Temperatur und der Verdampfereinrichtung (20) gekühlt wird.

2. Verfahren gemäß Anspruch 1, bei dem
- die Verdampfungstemperatur des Verdampfungsguts und die Innenkammer-Temperatur niedriger als die Umgebungstemperatur der Beschichtungsvorrichtung (100) sind.

3. Verfahren gemäß einem der vorhergehenden Ansprüche, mit mindestens einem der Merkmale
- die Verdampfungstemperatur ist im Bereich von -50 °C und 600 °C und die Innenkammer-Temperatur im Bereich von - 80 ° C und - 40 °C gewählt, und
- die Vakuumqualität ist im Bereich von 10⁻³ mbar und 10⁻¹⁰ mbar gewählt.

## Claims

1. Method of coating a substrate (1) by reactive vapor deposition under vacuum by means of a coating apparatus (100), which comprises
- an evacuable vacuum chamber (10),
- an evaporator device (20) being adapted to provide evaporation material in vapor phase and comprising at least one heat exchanger evaporator source (50), each including an organic precursor substance, and at least one active heating evaporator source (60), each including an inorganic precursor, and
- a substrate holder (30) being adapted to receive the substrate, wherein
- a temperature-controllable inner chamber (40) is arranged in the vacuum chamber (10), which inner chamber (40) surrounds a vapour section (41) between the evaporator device (20) and the substrate holder (30) and is arranged for setting an inner chamber temperature equal to or lower than 25°C, and
- the inner chamber (40) is coupled to a cooling device (42) by which the inner chamber temperature is adjustable, comprising the steps of
- transferring the evaporation material with the evaporator device (20) into the vapor phase, wherein the evaporator device (20) is adjusted to an evaporation temperature of the evaporation material and the inner chamber (40) is adjusted to the inner chamber temperature below the evaporation temperature of the evaporation material, and
- forming at least one layer on the substrate (1) by a reactive deposition of the evaporation material, wherein at least one hybrid organic/inorganic mixed layer or a perovskite layer is deposited from the at least one organic precursor substance and the at least one inorganic precursor substance, wherein
- the coating apparatus comprises a heating device (11), by which the vacuum chamber (10) outside the inner chamber (40) is heated independently of the temperature of the inner chamber (40) to an outer chamber temperature above the ambient temperature of the coating device (100), and
- the coating apparatus comprises at least one thickness gauge (12) being coupled to a temperature control device and being cooled independently of the adjustment of the inner chamber temperature and of the evaporator device (20).

2. Method according to claim 1, wherein
- the evaporation temperature of the evaporation material and the inner chamber temperature are lower than the ambient temperature of the coating device (100).

3. Method according to one of the foregoing claims, having at least one of the features
- the evaporation temperature is selected in the range from - 50 °C to 600 °C and the inner chamber temperature is selected in the range from - 80 ° C to - 40 °C, and
- the vacuum quality is selected in the range from 10⁻³ mbar to 10⁻¹⁰ mbar.

## Revendications

1. Procédé de revêtement d'un substrat (1) par dépôt réactif en phase vapeur sous vide au moyen d'un dispositif de revêtement (100) qui comprend :
- une chambre sous vide (10) dans laquelle le vide peut être fait,
- un système évaporateur (20), qui est mis au point pour fournir du produit d'évaporation dans la phase vapeur, et au moins une source d'évaporateur d'échangeur de chaleur (50), qui contient respectivement une substance précurseur organique, et au moins une source d'évaporateur de chauffage actif (60), qui contient respectivement une substance précurseur inorganique, et
- une fixation de substrat (30), qui est mise au point pour recevoir le substrat, dans lequel est disposée dans la chambre sous vide (10) une chambre intérieure (40) thermorégulable, qui entoure un tronçon à vapeur (41) entre le système évaporateur (20) et la fixation de substrat (30) et est mise au point pour un réglage d'une température de chambre intérieure inférieure ou égale à 25 °C, et
- la chambre intérieure (40) est couplée à un système de refroidissement (42), avec lequel la température de chambre intérieure peut être réglée, avec les étapes
- de transfert du produit d'évaporation avec le système évaporateur (20) dans la phase vapeur, dans lequel le système évaporateur (20) est réglé sur une température d'évaporation du produit d'évaporation et la chambre intérieure (40) est réglée sur la température de chambre intérieure sous la température d'évaporation du produit d'évaporation, et
- d'obtention d'au moins une couche sur le substrat (1) par un dépôt réactif du produit d'évaporation, dans lequel au moins une couche mixte organique/inorganique hybride ou une couche de pérovskite sont déposées à partir de l'au moins une substance précurseur organique et de l'au moins une substance précurseur inorganique, dans lequel
- le dispositif de revêtement (100) comprend un système de chauffage (11), avec lequel la chambre sous vide (10) est réchauffée à une température de chambre extérieure supérieure à la température ambiante du dispositif de revêtement (100) à l'extérieur de la chambre intérieure (40) indépendamment de la température de la chambre intérieure (40), et
- le dispositif de revêtement (100) comprend au moins un appareil de mesure d'épaisseur (12), qui est couplé à un système de thermorégulation et est refroidi indépendamment du réglage de la température de chambre intérieure et du système d'évaporation (20).

2. Procédé selon la revendication 1, où
- la température d'évaporation du produit d'évaporation et la température de chambre intérieure sont inférieures à la température ambiante du dispositif de revêtement (100).

3. Procédé selon l'une quelconque des revendications précédentes, avec au moins une des caractéristiques
- la température d'évaporation est choisie dans la plage de -50 °C et 600 °C et la température de chambre intérieure est choisie dans la plage de -80 °C à -40 °C, et
- la qualité de vide est choisie dans la plage de 10⁻³ mbar et 10⁻¹⁰ mbar.
